# EUROPEAN PATENT APPLICATION

(11) **EP 4 219 170 A1**
(43) Date of publication of application: **02.08.2023**
(21) Application number: 20961602.8
(22) Date of filing: 13.11.2020
(51) Int. Cl.: B41J 2/01

(54) **PRINTING METHOD AND INKJET RECORDING DEVICE**

(71) Applicant: KONICA MINOLTA, INC., Tokyo 100-7015 (JP)
(72) Inventor: KURAMOCHI, Shouhei, Tokyo 100-7015 (JP); OSADA, Kohei, Tokyo 100-7015 (JP)
(74) Representative: Gille Hrabal Partnerschaftsgesellschaft mbB Patentanwälte
(86) International application number: PCT/JP2020/042393
(87) International publication number: WO 2022/102074

(57) **Abstract**

A printing method and an inkjet recording device are provided that can more reliably perform printing on a print medium surface having a step. In a printing method performed by discharging ink on a base component (S) having a step portion, the step portion includes three regions that are an inclined portion (E) that forms a step, an upper adjacent portion (UC) that is adjacent to the inclined portion (E) and has a predetermined width, and a lower adjacent portion (LC) that is adjacent to the inclined portion (E) and has a predetermined width, and the method includes a discharge amount setting step of increasing an ink droplet amount per ink discharge cycle of discharge to at least any selected region among the three regions, more than the ink droplet amount of discharge to what is other than the three regions.

## Description

### TECHNICAL FIELD

The present invention relates to a printing method and an inkjet recording device.

### DESCRIPTION OF THE RELATED ART

There is a technology of performing a print operation by discharging ink on a print medium surface having a three-dimensional structure. Patent Literature 1 discloses a technology of discharging a larger amount of ink at and around the center of a convex than at its ends in order to prevent ink landed on the convex from flowing to concaves and prevent the amount of ink on the convex from being insufficient.

### CITATION LIST

### PATENT LITERATURE

[Patent Literature 1] JP 2018-202635A

### SUMMARY OF THE INVENTION

### TECHNICAL PROBLEM

There is, however, a problem that if the ink flows down at a step portion of the three-dimensional structure, the ink tends to flow down at corners of the step, the ink does not remain there and the print medium surface is exposed in some cases, which prevents desired printing from being reliably performed.

The present invention has an object to provide a printing method and an inkjet recording device that can more reliably perform printing on a print medium surface having a step.

### SOLUTION TO PROBLEM

In order to achieve the object described above, an invention according to claim 1 is
a printing method performed by discharging ink on a base component having a step portion,
wherein the step portion includes three regions that are an inclined portion that forms a step, an upper adjacent portion that is adjacent to the inclined portion and has a predetermined width, and a lower adjacent portion that is adjacent to the inclined portion and has a predetermined width, and
the method includes a discharge amount setting step of increasing an ink droplet amount per ink discharge cycle of discharge to at least any selected region among the three regions, more than the ink droplet amount of discharge to what is other than the three regions.

An invention according to claim 2 is the printing method according to claim 1,
wherein the contains a gelator.

An invention according to claim 3 is the printing method according to claim 1 or 2,
wherein a distribution of the ink droplet amount to the selected region is uneven.

An invention according to claim 4 is the printing method according to claim 3,
wherein the selected region includes at least two of the three regions, and
the ink droplet amounts to the at least two regions are different from each other.

An invention according to claim 5 is the printing method according to any one of claims 1 to 4,
wherein the selected region is defined in accordance with a material of the base component.

An invention according to claim 6 is the printing method according to any one of claims 1 to 5,
wherein the base component is a wiring substrate that includes an insulating substrate, and a wiring conductor positioned on the insulating substrate, and
the ink is a solder mask ink.

An invention according to claim 7 is the printing method according to any one of claims 1 to 6,
wherein the ink is cured by irradiation with predetermined energy rays.

An invention according to claim 8 is the printing method according to claim 7,
wherein the predetermined energy rays are ultraviolet light.

An invention according to claim 9 is the printing method according to any one of claims 1 to 8,
wherein the ink has a thermosetting property.

An invention according to claim 10 is an inkjet recording device that includes:
a discharge operator that discharges ink; and
a controller,
wherein
when printing is performed by discharging ink on a base component including a step portion that includes three regions that are an inclined portion that forms a step, an upper adjacent portion that is adjacent to the inclined portion and has a predetermined width, and a lower adjacent portion that is adjacent to the inclined portion and has a predetermined width,
the controller increases an ink droplet amount per ink discharge cycle of discharge to at least any selected region among the three regions, more than the ink droplet amount of discharge to what is other than the three regions.

### ADVANTAGEOUS EFFECTS OF INVENTION

According to the present invention, an advantageous effect of allowing more secure printing on a print medium surface having a step can be exerted.

### BRIEF DESCRIPTION OF THE DRAWINGS

[FIG. 1A] FIG. 1A is a front view illustrating a schematic configuration of an inkjet recording device according to an embodiment of the present invention.
[FIG. 1B] FIG. 1B is a plan view of the inkjet recording device.
[FIG. 2] FIG. 2 is a block diagram showing a functional configuration of the inkjet recording device.
[FIG. 3A] FIG. 3A is a diagram illustrating a print range on a wiring substrate.
[FIG. 3B] FIG. 3B illustrates the print range on the wiring substrate.
[FIG. 4] FIG. 4 shows three types of examples of distribution of ink discharge amounts.
[FIG. 5A] FIG. 5A illustrates increase in ink discharge amount.
[FIG. 5B] FIG. 5B illustrates increase in ink discharge amount.
[FIG. 5C] FIG. 5C illustrates increase in ink discharge amount.
[FIG. 6] FIG. 6 is a flowchart showing control procedures of a printing control process.
[FIG. 7A] FIG. 7A illustrates an example of the ink discharge amount in a case of printing by two scans.
[FIG. 7B] FIG. 7B illustrates an example of the ink discharge amount in the case of printing by two scans.
[FIG. 8] FIG. 8 illustrates Modification 1 of the ink discharge amount in the case of printing by two scans.
[FIG. 9] FIG. 9 illustrates Modification 2 of the ink discharge amount in the case of printing by two scans.
[FIG. 10A] FIG. 10A illustrates Modification 3 of the ink discharge amount in the case of printing by two scans.
[FIG. 10B] FIG. 10B illustrates Modification 3 of the ink discharge amount in the case of printing by two scans.
[FIG. 10C] FIG. 10C illustrates Modification 3 of the ink discharge amount in the case of printing by two scans.
[FIG. 11A] FIG. 11A illustrates Modification 4 of the ink discharge amount in the case of printing by two scans.
[FIG. 11B] FIG. 11B illustrates Modification 4 of the ink discharge amount in the case of printing by two scans.
[FIG. 11C] FIG. 11C illustrates Modification 4 of the ink discharge amount in the case of printing by two scans.
[FIG. 12A] FIG. 12A shows an example of a drive waveform.
[FIG. 12B] FIG. 12B shows an example of a drive waveform.
[FIG. 12C] FIG. 12C shows an example of a drive waveform.

### DETAILED DESCRIPTION OF EMBODIMENT

Hereinafter, an embodiment of the present invention is described with reference to the drawings.

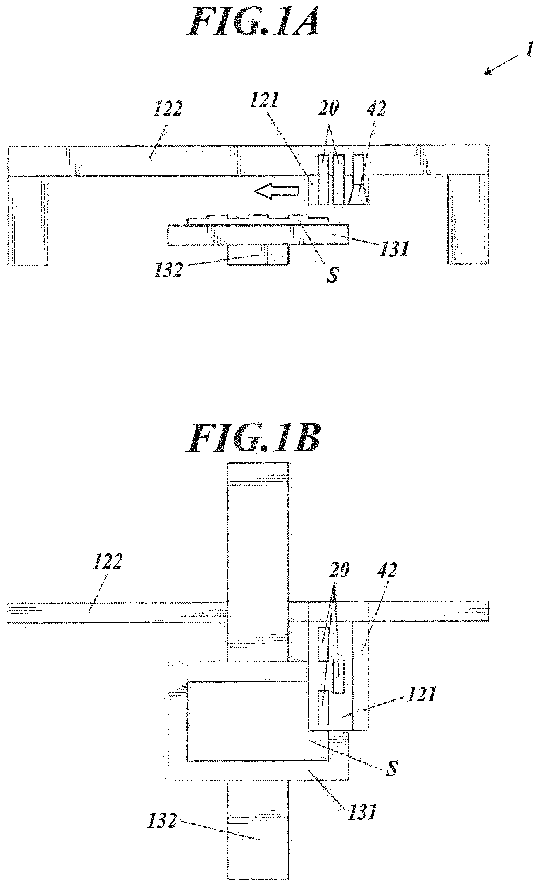

FIG. 1A is a front view illustrating a schematic configuration of an inkjet recording device 1 according to the embodiment of the present invention. FIG. 1B is a plan view of the inkjet recording device 1.

The inkjet recording device 1 includes an inkjet head 20 (discharge operator), a UV irradiator 42, a scanner 121, a scan guide 122, a conveyance table 131, and a conveyance guide 132.

An ink discharge target in the inkjet recording device 1 in this embodiment is, for example, a wiring substrate S (base component). The wiring substrate S is mounted on the conveyance table 131. The conveyance table 131 can move in a direction (a conveyance direction, and a sub-scanning direction) along the conveyance guide 132, such as a rail, in a state of being mounted with the wiring substrate S. The wiring substrate S includes a substantially plate-shaped conductor (wiring conductor) where signal wiring is formed on an insulating substrate. Although not specifically limited, the conductor is, for example, copper (copper foil) or the like. The signal wiring is positioned so as to protrude on the insulating substrate surface, thus making the wiring substrate S include a step portion. Landed ink does not permeate into the wiring substrate S, but bulges on the surface, is cured and fixed. Here, the insulating substrate surface is a plane, and a vertically outward direction with respect to this plane is assumed as an upward direction.

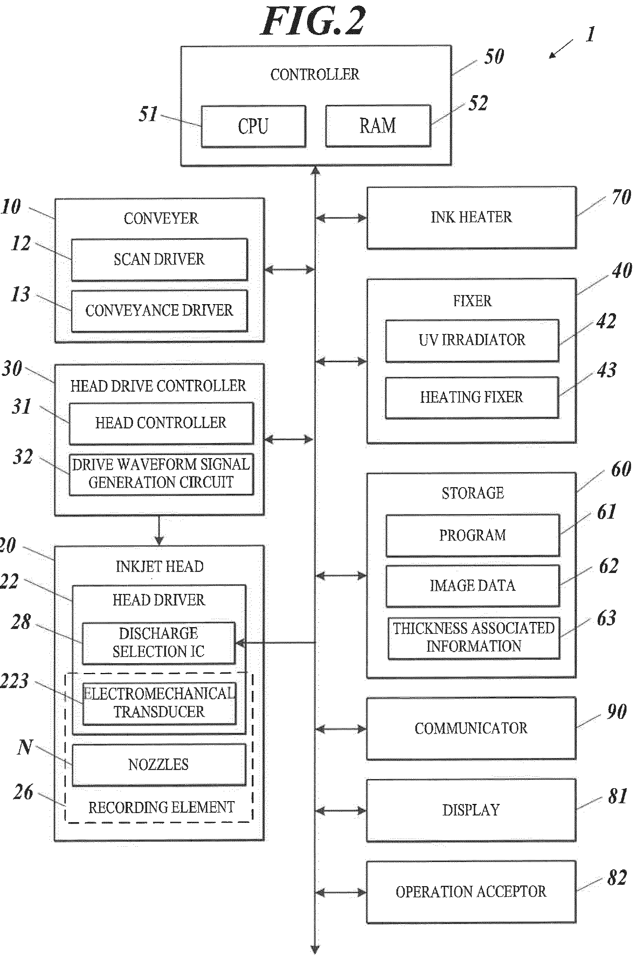

The inkjet head 20 includes nozzles N (see FIG. 2), and discharges ink toward the wiring substrate S through the nozzles N. The ink discharge amount to each pixel region at each ink discharge cycle can be selected from among multiple degrees. The UV irradiator 42 irradiates the wiring substrate S, on which ink is landed, with ultraviolet light (UV light). The inkjet head 20 and the UV irradiator 42 are fixed to the scanner 121, and is moved (scanning) in a direction along the scan guide 122 (a scanning direction; i.e., a direction intersecting with the movement direction of the conveyance table 131; here, an orthogonal direction). For example, a linear motor or the like may be used to move them. The nozzles of the inkjet head 20 are arranged over the width of the wiring substrate S. Definition of a sufficiently small nozzle arrangement interval may allow printing to be completed by one scan (single path). While the wiring substrate S is moved, scanning of the inkjet head 20 is repeated multiple times, thereby allowing multi-path (interlace) ink discharge.

FIG. 2 is a block diagram showing a functional configuration of the inkjet recording device 1.

The inkjet recording device 1 includes a conveyer 10, the inkjet head 20 (ink discharger), a head drive controller 30, a fixer 40, a controller 50, a storage 60, an ink heater 70, a display 81, an operation acceptor 82, and a communicator 90. The controller 50 and each component are communicably connected to each other via a bus and the like.

The conveyer 10 relatively moves the inkjet head 20, and a medium serving as an image (film) formation target, here, a wiring substrate S, with respect to each other. As described above, for example, the inkjet head 20 can move in a predetermined direction (scanning direction) with respect to the wiring substrate S, and the wiring substrate S can move in the vertical direction with respect to the scanning direction of the inkjet head 20.

The conveyer 10 includes a scan driver 12, and a conveyance driver 13. The scan driver 12 performs scanning by moving the inkjet head 20 and the scanner 121. The scan driver 12 includes, for example, a linear motor, and moves the inkjet head 20 directly, or indirectly through a fixation member of the inkjet head 20.

The conveyance driver 13 moves mounted members, such as a base (conveyance table 131) mounted with the wiring substrate S, and a belt, for example. The conveyance driver 13 can move the mounted members in a reciprocating manner.

The inkjet head 20 includes a head driver 22, and a plurality of nozzles N. According to a drive signal output from the head driver 22, ink is discharged from the nozzles N. The head driver 22 includes a discharge selection IC 28 (Integrated Circuit), and an electromechanical transducer 223. The discharge selection IC 28 performs a switching operation so that the drive signal in accordance with presence or absence of ink discharge and the discharge amount from each nozzle N based on image data can be output to the electromechanical transducer 223 associated with the corresponding nozzle N. The electromechanical transducer 223 is, for example, a piezoelectric element. Change in shape is caused according to the input drive signal. The change in shape causes variation in pressure of ink in an ink flow path communicating with the corresponding nozzle N.

The electromechanical transducer 223 and the nozzles N constitute a recording element 26.

The head drive controller 30 includes a head controller 31 and a drive waveform signal generation circuit 32, and outputs a drive waveform signal (analog signal) pertaining to ink discharge and the like, at a predetermined time cycle (ink discharge cycle) to the inkjet head 20, based on output data (digital data) from a drive waveform signal generation circuit 32. The drive waveform signal pertaining to ink discharge may be a combination of multiple pulse signals. In accordance with ink discharge amounts, drive waveform signals having multiple types of different waveform patterns (including not only waveforms, but also variation in pulse length, amplitude, voltage value, etc.) may be respectively output. Alternatively, multiple continuous drive pulses in accordance with the ink droplet amount per pixel may be output (multi-pulse scheme). In this case, ink droplets discharged by the corresponding driving pulses are joined together during flight, or are landed in the same pixel region. Ink discharged from each nozzle to the corresponding pixel per path (one cycle) may have an ink droplet amount for achieving a minimum thickness (e.g., 15 µm) of an insulating film described later, in consideration also of the surface characteristics of the wiring substrate S, the temperature at ink discharge (viscosity characteristics), and a time interval from ink droplet landing to temporary fixation by UV light irradiation by the UV irradiator 42. Output can be performed not only in the case of discharging ink, but also in other cases of a non-discharge waveform pattern for agitating ink in each nozzle N.

In addition to or instead of the method described above, another method that adjusts the state of the ink liquid surface (meniscus) in the nozzle N by adjusting the state of the pressure of ink in a state where no driving pulse is applied (normally, a negative pressure for preventing ink from leaking), or changes and adjusts the driving frequency, for example, may be applicable to control of the ink discharge amount (landing amount) per pixel. Alternatively, the ink droplet amount can be adjusted also by preliminarily applying an appropriate non-discharge waveform pattern before a waveform pattern for discharging ink, and applying a driving pulse having a drive waveform pattern in a state where the meniscus is caused to vibrate.

Ink discharged in the inkjet recording device 1 in this embodiment may be solder mask ink, for example. The solder mask ink is ink to be discharged on the wiring substrate S to form an insulating film (solder mask) on the wiring substrate S. Here, the solder mask ink is cured by irradiation with predetermined energy rays, ultraviolet light (UV) in this case. Furthermore, the solder mask ink has a thermosetting property.

The solder mask ink contains a compound that has a thermosetting functional group. The thermosetting functional group may be any of various publicly known ones, for example, (specifically, two or more) isocyanate groups. Polyfunctional isocyanate groups (block isocyanate) where isocyanate groups are protected by a thermal dissociative blocking agent are preferable in view of increase in high temperature and high humidity resistance, and improvement in ink preservability. Although the thermal dissociative blocking agent is not specifically limited, the agent may be, for example, a compound containing at least one type of an oxime series compound, a pyrazole series compound, an activated ethylene series compound and the like.

Alternatively, the thermosetting functional group may be, for example, an acryl group or a methacryl group, in particular, an acrylate compound or a methacrylate compound, such as an imide acrylate, having an imide group. An imide group has a high polarity, and can obtain an adhesion property to a strong metal (i.e., wiring on the wiring substrate S). Owing to the strong cohesion, metal adhesion property is less affected by even at a high humidity.

On the other hand, as a component pertaining to curing due to irradiation with UV light in solder mask ink, the ink contains a compound having a photopolymerizable functional group, and a photopolymerization initiator. The photopolymerizable compound is only required to be any of various types of compounds that have an ink curing action of polymerization by irradiation with activation energy rays (UV light) or cross-linkage through a crosslinking reaction, and may be, for example, a radical polymerization compound, or a cationic polymerization compound. A polymerizable compound having an imide group, such as the imide acrylate, also has UV curability. A photopolymerization initiator is in accordance with the type of the photopolymerizable functional group (compound).

The solder mask ink contains a gelator. The ink is in a gel state at an ordinary temperature, a phase-change to and from a sol state is caused in accordance with the temperature, and the viscosity rapidly changes. The gelator may be, for example, at least any one of types of compounds represented by a general formula (G1) or (G2) described below.

General formula (G1): R₁-CO-R₂

General formula (G2): R₃-COO-R₄

In these formulae, R₁ to R₄ independently represent an alkyl chain that has a straight-chain portion having a carbon number of 12 or more, and may have a branch. Such a gelator does not inhibit the curability of ink, and is distributed in a cured film. Accordingly, the moisture resistance of a printed and formed ink film (solder mask) is improved, which prevents moisture from permeating into the cured film. Furthermore, this also improves insulation reliability. The ink containing the gelator has a favorable pinning property. It is also preferable that formation of a film achieving both a fine line and film thickness be facilitated (i.e., excellent in fine line reproducibility even in a case where a certain film thickness is required).

The fixer 40 performs an operation of fixing ink landed on the wiring substrate S. As described above, the ink has a thermosetting property and curability due to activation energy rays (UV light). Accordingly, to support these, the fixer 40 includes an UV irradiator 42 and a heating fixer 43. Although not specifically limited, here, the UV irradiator 42 is fixed, together with the inkjet head 20, to the scanner 121, and through scanning, temporarily fixes ink landed on the wiring substrate S. For example, the UV irradiator 42 includes a light emitting diode (LED) that emits ultraviolet light. A voltage is applied to the LED and current flows and light is emitted, thus achieving irradiation with ultraviolet light (UV light). As required, the UV irradiator 42 may include a light-shielding wall for blocking leakage of UV light to the outside of a desired irradiation range.

Note that in the UV irradiator 42, a component of emitting UV light is not limited to the LED. The UV irradiator 42 may include, for example, a mercury lamp. In a case where the ink has a property of being cured and fixed by reception of activation energy rays other than UV light, the UV irradiator 42 may include a publicly known emission source (light source) that emits activation energy rays for curing the ink, instead of the aforementioned component of emitting UV light.

The heating fixer 43 includes, for example, a heat generator, such as an infrared heater or a heating wire, and directly or indirectly heats the wiring substrate S and actually fixes the preliminarily fixed ink. The heating fixer 43 is positioned so that after ink landing and temporary fixation by the inkjet head 20 and the UV irradiator 42, the wiring substrate S is conveyed downstream in the conveyance direction and then actual fixation is performed, for example. The heating fixer 43 may be positioned in a housing that surrounds a region including the wiring substrate S and part of a conveyance member mounted with this substrate; this positioning may maintain heat generated by the heat generator in the housing, and maintain the heat effectively at an appropriate curing temperature. In this case, the heat generator is not necessarily always operated during heating. It is only required that the temperature is maintained in a setting range pertaining to the curing temperature described above.

Note that the heating fixer 43 is not necessarily included in the inkjet recording device 1, but may be included in a separate heating and fixing device instead. The heating and fixing device may be a post-processing apparatus of the inkjet recording device 1, and the conveyer 10 may be capable of feeding the wiring substrate S directly to the heating and fixing device residing on an extended line in the movement direction of the conveyance table 131. A configuration may be provided that resets, to the heating and fixing device, the wiring substrate S taken out from the conveyance table 131 of the inkjet recording device 1, or a user may manually move the wiring substrate S.

The controller 50 integrally controls the operation of each component of the inkjet recording device 1. The controller 50 includes a CPU 51 (central processing unit), and a RAM 52 (random access memory). The CPU 51 is a hardware processor that performs various operation processes, and executes a program 61 stored in the storage 60. The RAM 52 supplies the CPU 51 with a memory space for control, and temporarily store data.

The storage 60 includes at least a nonvolatile memory, and stores the program 61 and setting data. The nonvolatile memory may be, for example, a flash memory. An HDD (Hard Disk Drive) and the like may be encompassed by the nonvolatile memory. The storage 60 may include a RAM that temporarily stores image data 62 that indicates a formation (cover) range of a film to be formed, and data for driving the inkjet head 20 processed and generated based on the image data 62. The program 61 includes a control program pertaining to ink discharge control process and a cover range adjusting process, described later. The setting data includes thickness associated information 63 that includes information pertaining to the ink discharge amount in association with the thickness of a film to be formed. The resolution of information on the cover range (setting range) indicated by the image data 62 is not specifically limited, but may be, for example, 1440 dpi (dot per inch) or higher.

The ink heater 70 heats ink in the inkjet head 20 and an ink supply path to the inkjet head 20, and maintains the ink at an appropriate temperature. As described above, the phase of the ink is changed between sol and gel owing to the temperature. Accordingly, in the gel state at an ordinary temperature, the fluidity is insufficient, and ink supply and discharge are difficult. By heating the ink to an appropriate temperature, the ink heater 70 maintains the ink in the sol state, and allows supply and appropriate discharge. The appropriate temperature may be defined so that after ink landing on the wiring substrate S, heat is quickly released by the wiring substrate S and the like, and gelification is achieved in an appropriate time. The ink heater 70 includes, for example, a heating wire, and a sheet member (rubber etc.) to be heated with heat generated by the heating wire. The sheet member is in contact with the ink supply path etc., and transfers heat, thus heating the ink.

Based on control by the controller 50, the display 81 displays various statuses, menus and the like on a display screen. The display 81 includes, for example, the display screen, and LED (Light Emitting Diode) lamps. Although not specifically limited, the display screen may be an LCD (Liquid Crystal Display), for example. For example, in accordance with a power supply situation, an abnormality occurrence situation and the like, the controller 50 causes LED lamps to turn on lamps at positions and colors in accordance with the corresponding situations (including a blinking operation).

The operation acceptor 82 accepts an input operation from the outside by a user or the like, and outputs the operation as an input signal to the controller 50. The operation acceptor 82 includes, for example, a touch panel, and a push button switch. The touch panel may be positioned in a manner overlaid on the display screen of the display 81. The operation acceptor 82 may include other various operation switches.

The communicator 90 controls transmission and reception of data (signal) to and from an external device and the like in conformity with a predetermined communication standard. The communicator 90 controls communication in conformity with a LAN (Local Area Network) standard, for example. External devices and the like may be connectable to the communicator 90 in conformity with a USB (Universal Serial Bus) standard.

Next, a print operation in the inkjet recording device 1 in this embodiment is described.

During scanning, every ink discharge cycle, the inkjet recording device 1 discharges ink from the inkjet head 20 to pixels on a certain scanning line (in a case where multiple rows of nozzles N are arranged with respect to the scanning direction, these rows are included), subsequently moves the inkjet head 20 by the scan driver 12, and causes the nozzles N to face pixels on another scanning line. In a case where ink is discharged by multipath, scanning is performed while changing the positional relationship between the wiring substrate S on the conveyance table 131 and the nozzles N (pixels as ink discharge targets on the scanning line) on each path. UV irradiation by the UV irradiator 42 is performed on each scan.

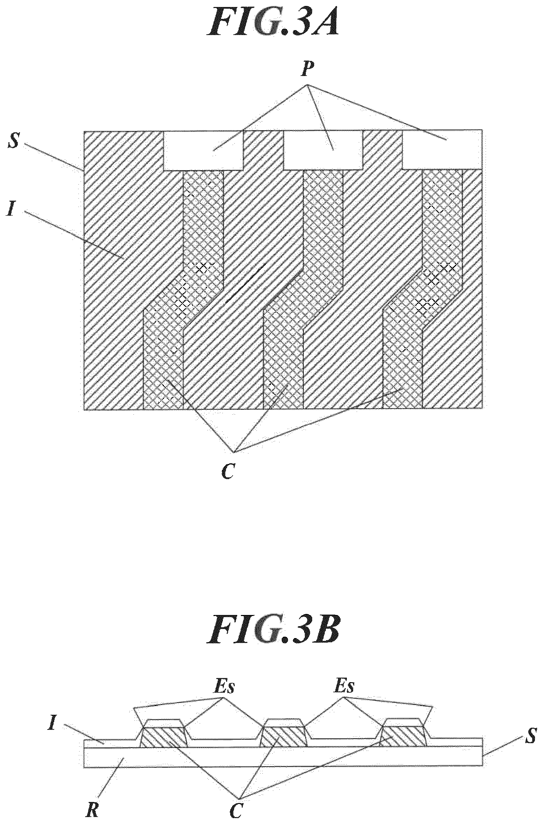

FIGS. 3A and 3B illustrate a print range on the wiring substrate S.

Solder mask ink is used to provide an insulating film I (solder mask) on the wiring substrate S. For the insulating film I, a print range (i.e., a cover range) is defined on the wiring substrate S in accordance with signal wiring C and the like on an insulating substrate R, and is held as the image data 62. The insulating film I includes openings and slits, such as of a circular shape, a circular ring shape, a rectangular shape, and a fine line, in accordance with ranges forming connection pads P where the signal wiring C positioned on the insulating substrate R is connected to electronic components, external signal wiring lines and the like. The thickness of the insulating film I is equal to or more than a thickness required to secure insulation. Although not specifically limited, for example, the thickness ranges from 15 to 30 µm.

As shown in FIG. 3B, the surface of the insulating film I has concaves and convexes in conformity with concaves and convexes of the wiring substrate S in accordance with presence or absence of the signal wiring C. At step portions of the concaves and convexes, landed ink tends to flow toward the concaves before being cured and fixed. As a result, only by uniform discharge of ink, ink does not remain around edges (shoulder portions Es) of upper portions of the step (on the convex side), print is discontinuous, the signal wiring C is exposed, and the insulation cannot be achieved in some cases.

During scanning (on at least any of paths in the multipath case), the inkjet recording device 1 in this embodiment increases the ink discharge amount (the ink droplet amount to be discharged to and landed on each pixel position) at at least any of step portions, and lower flat portions and upper flat portions connected to the step portions in comparison with the ink discharge amount to the other flat portions.

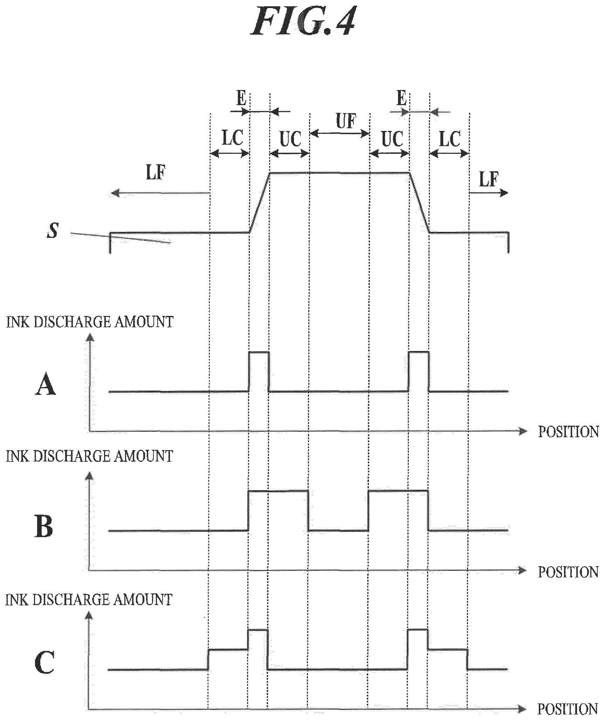

FIG. 4 shows three types of examples of distribution of ink discharge amounts.

Typically, each side surface of the signal wiring C does not completely vertically rise from the insulating substrate R, and has a slight inclined region E (inclined portion). A lower connection LC (lower adjacent portion) having a predetermined width on the insulating substrate R adjacent to the inclined region E, and an upper connection UC (upper adjacent portion) having a predetermined width on the signal wiring C adjacent to the inclined region E (i.e., both the sides form the inclined region E) are defined. The ink discharge amount (the ink droplet amount of discharge) to at least any selected region among the inclined region E, lower connection LC and upper connection UC (collectively called three step regions (three regions)) is defined larger than (increased in comparison with) the ink discharge amount (the ink droplet amount of discharge) to the remaining flat portions LF and central flat portion UF of the signal wiring C (portions other than the three regions). Note that the inclined region E is not limited to a flat surface, but may be a curved surface or the like, and what has concaves and convexes with respect to an average inclined surface. Although not specifically limited, typically, the width of the inclined region E is narrow with respect to the height, to an extent of being regarded as a step. Likewise, each of the predetermined widths of the upper connection UC and the lower connection LC may be any width only if the width is about that of one pixel. For example, each of the predetermined widths of the upper connection UC and the lower connection LC may be about the diameter of a landing range of ink droplets landing on the flat portions UF and LF (may be with reference to a large (increased) one of the ink discharge amounts of multiple degrees) (although not specifically limited, typically, the width of one pixel, for example, equivalent to 10.6 µm or higher in a case of 2400 dpi; 1 to 15 times larger than this in many cases) (in a case where the landing ranges vary depending on the difference between the materials of the flat portions UF and LF, any one may be adopted as a reference, or an average value may be adopted as a reference). That is, each of the predetermined widths of the upper connection UC and the lower connection LC may be about the landing range of ink to be joined to the ink droplet landed in the inclined region E, and/or to an extent where at least part of the landing range reliably includes the ink droplet extending to the inclined region E. The predetermined widths of the upper connection UC and the lower connection LC may be different from each other (the predetermined width of the upper connection UC may be defined based on the landing range to the flat portion UF, or the predetermined width of the lower connection LC may be defined based on the landing range to the flat portion LF). In a case where the wiring width is narrow or the wiring interval is narrow, there may be a portion that does not have the flat portion UF or the flat portion LF depending on the situation.

In an example indicated by a pattern A, only the ink discharge amount to the inclined region E is defined larger than the ink discharge amount to every other portion. In an example indicated by a pattern B, the ink discharge amount to the upper connection UC is also increased, in addition to the inclined region E. In an opposite manner, in an example indicated by a pattern C, the ink discharge amount to the lower connection LC is also increased, in addition to that to the inclined region E. At this time, in any of the three step regions, the amounts of increase in ink discharge amounts may be different between the regions where the ink discharge amounts increase. Here, the amount of increase in the inclined region E is larger than the amount of increase in the lower connection LC. In other cases, the amounts of increase in the three step regions may be independently defined to ununiform (uneven) ink discharge amounts.

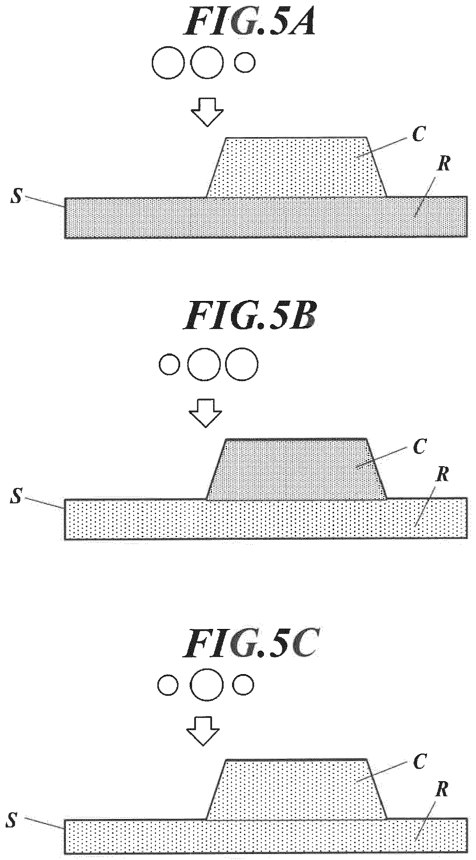

FIGS. 5A to 5C illustrate increase in ink discharge amount.

Among the three step regions, the size of each region and the region where the ink discharge amount is increased may be defined in accordance with the material and the surface characteristics of the wiring substrate S. For example, by discharging more ink at a portion having a higher wettability, ink shortage due to flowing out is suppressed. As shown in FIG. 5A, in a case where the wettability of the insulating substrate R is higher than the wettability of the signal wiring C, more ink is discharged to the inclined region E and the lower connection LC. Here, the sizes of three circles indicate whether the amount of ink is large or small.

As shown in FIG. 5B, in a case where the wettability of the insulating substrate R is lower than the wettability of the signal wiring C, more ink may be discharged to the inclined region E and the upper connection UC. As shown in FIG. 5C, in a case where both the insulating substrate R and the signal wiring C are made of a material having a low wettability (the magnitude of the wettability here may be defined by comparing the spreading size of landed ink with a reference size, for example), only the ink discharge amount to the inclined region E may be increased. In this case, the effect of spreading due to a pull by joining to adjacently landed ink is sometimes larger than the spreading characteristics of the ink droplet to the wiring substrate S. Accordingly, it is conceivable that by not increasing the ink discharge amounts to the upper connection UC and the lower connection LC, the ink droplet landed in the inclined region E is relatively resistant to being pulled to both the side.

In actuality, boarders of pixels do not correctly coincide with the respective boarders of the three step regions in many cases. Some ink droplets are each landed so as to reside between multiple regions. In such cases, for example, the corresponding region may be defined based simply on the landing center position (the barycenter position etc. Flowing out due to an inclination or the like is not required to be considered). The discharge amount may be calculated and adjusted based on the rates belonging to multiple regions and on the ink discharge amounts to the regions. The widths (predetermined widths) of the upper connection UC and the lower connection LC may be fixed widths, or defined in accordance with the ink spreading characteristics (material) in the corresponding regions, the size (height) of the step and the like. The widths of the upper connection UC and the lower connection LC may be different from each other.

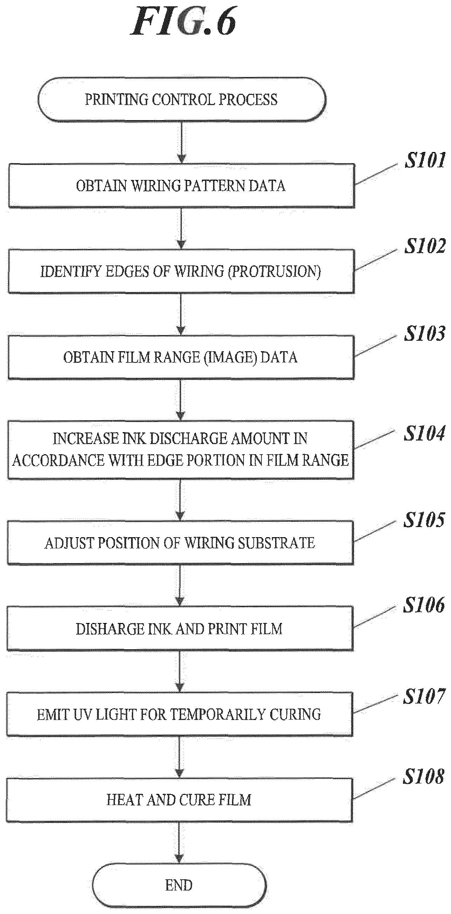

FIG. 6 is a flowchart showing control procedures by the CPU 51 (controller 50) of a printing control process in this embodiment. The printing control process may be started when a printing instruction is obtained together with image data indicating the cover range from an external device or the like (data obtaining timing and instruction obtaining timing may be different from each other).

When the printing control process is started, the CPU 51 (controller 50) obtains wiring pattern data on the wiring substrate S (step S101). The CPU 51 identifies edges of wiring from the wiring pattern data, i.e., step portions (step S102).

The CPU 51 obtains image data indicating the printing (ink discharge) range (step S103). For a portion of overlapping the edge position in the image data range, the CPU 51 increases the ink discharge amount to at least any of the three step regions according to a predetermined condition (step S104).

The CPU 51 adjusts the position of the wiring substrate S in accordance with the image data (step S105). Adjustment may be performed by defining an offset value and the amount of rotation, for a normal position where the wiring substrate S is mounted, for example. The adjustment may be automatically performed by CPU 51, or may be performed partially through manual operation (input operation etc.) by the user. The CPU 51 causes the inkjet head 20 to discharge ink, based on changed image data, and print a film (insulating film I) (step S106).

The CPU 51 operates the UV irradiator 42, which irradiates the wiring substrate S with UV light, thus temporarily curing ink on the wiring substrate S (step S107). The CPU 51 heats the wiring substrate S, and cures and fixes the film (insulating film I) (step S108). The CPU 51 finishes the printing control process.

The aforementioned operation is described for the single-path printing. In a case of multipath printing, ink discharge by multiple times of, for example, two scans can be performed at regular intervals or complementarily. Also in the case of three or more scans, ink may be discharged while causing the phase to deviate at regular intervals on each scan. Alternatively, the pattern of the positions and order of multipath ink discharge may be based on another method. However, in the inkjet recording device 1 (printing method) in this embodiment, multiple scans are not performed by control of multiple times of ink discharge in accordance with the ink discharge amount, on each pixel. That is, before and/or after scanning of selectively discharging ink is performed only at a position where the ink discharge amount is increased, no control of uniform ink discharge in remaining scans is performed. In other words, in at least any scan, the discharge amount of ink is ununiform in accordance with the ink droplet amount for each pixel (except presence or absence of ink discharge).

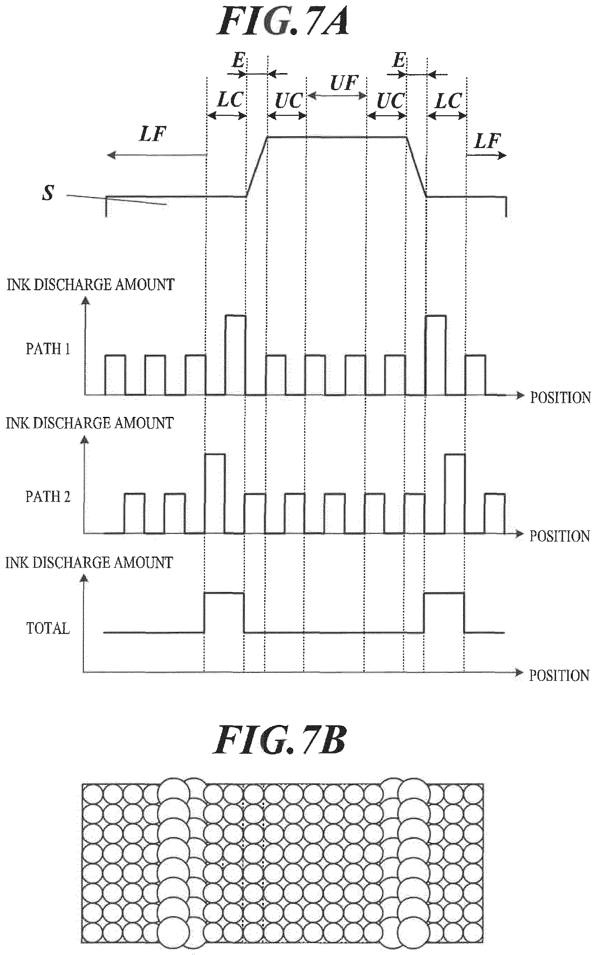

FIGS. 7A and 7B illustrate an example of the ink discharge amount in the case of printing by two scans (two paths).

FIG. 7A shows the example of increasing the ink discharge amount in the lower connection LC on a first and second paths.

FIG. 7B schematically shows the ink discharge amount (landing amount) on each pixel position. In actuality, the ink landing range is larger than the pixel region. However, here, for the sake of description, the landing range by a normal ink discharge amount coincides with the pixel region. Each pixel where the ink discharge amount is increased is indicated by a circle larger than the pixel region. In FIG. 7B, for example, from ink discharge to pixels on the top row (lateral arrangement), discharge target pixels move to a lower row by one row in accordance with scanning in one discharge cycle. Here, the shoulder portion extending direction is illustrated to be parallel with the scanning direction. During scanning, the nozzle where the ink discharge amount is increased is fixed. However, in a case where the shoulder portion extending direction is not in parallel with the scanning direction, the nozzle where the ink discharge amount is increased sequentially moves in accordance with the scanning position.

As described above, by combining two paths of discharge, a distribution where the ink discharge amount to the lower connection LC is larger than the ink discharge amount to each of the other portions can be obtained.

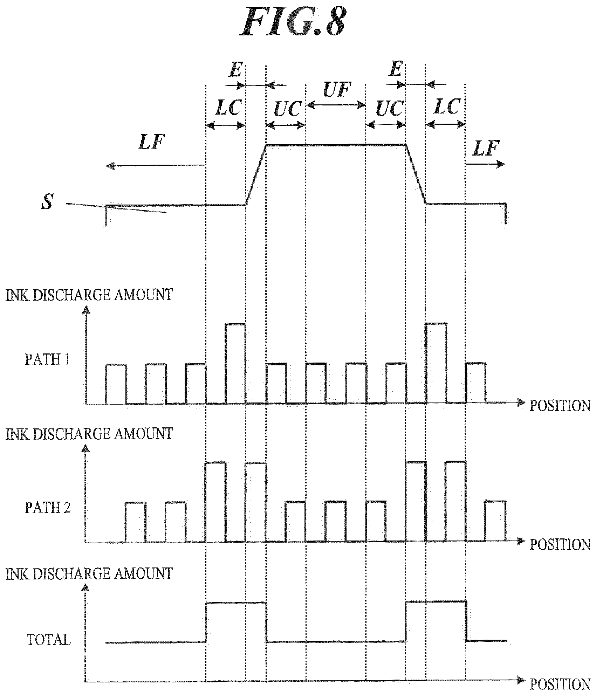

FIG. 8 illustrates Modification 1 of the ink discharge amount in the case of printing by two scans (two paths).

Here, in the second path, the ink discharge amounts to the lower connection LC and the inclined region E are defined larger than those to the other regions. In this case, timing may be controlled so that in the first scan (path 1), the ink discharge amount increases only to each lower connection LC, and in the second scan (path 2), increased ink discharge is performed to each inclined region E. By supplying a more amount of ink to each lower connection LC first and temporarily curing this, ink discharged to each inclined surface is prevented from being spreadable toward the lower connection LC in the second scan.

As described above, in the case where the scanning direction is not in parallel with the shoulder portion extending direction, it is difficult to completely align the discharge order. However, in a case where the three step regions each have a width for multiple pixels, and a case where the same amount of discharge cannot be performed to every pixel owing to the spread of the ink droplet and the upper limit of the discharge amount per unit area to the wiring substrate S, it may be set so that pixels with selectively increased ink discharge amounts can be subjected to discharge in the order described above as much as possible.

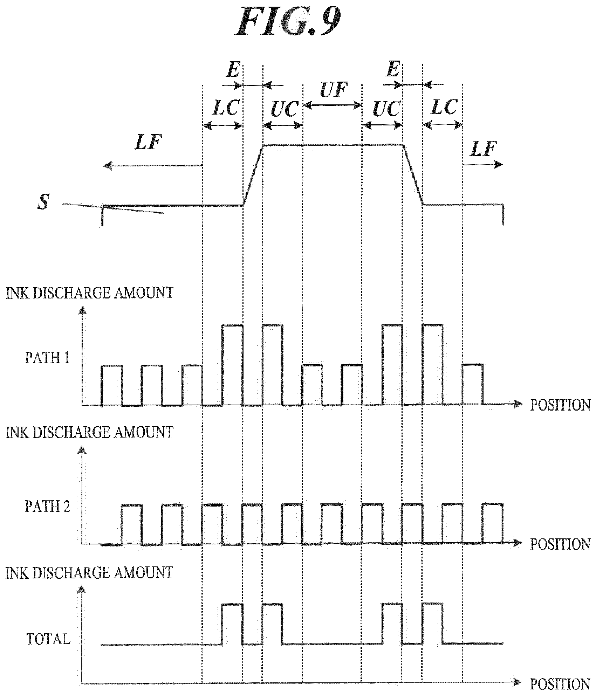

FIG. 9 shows Modification 2 of the ink discharge amount in the case of printing by two scans.

In this diagram, by two-path ink discharge, the ink discharge amounts to the lower connection LC and the upper connection UC are increased. In this case, the increased ink discharge to the lower connection LC and the upper connection UC are performed in the first path. In a case where the inclined region E is steep (nearly vertical) and a case where the wettability on the conductive surface is high, it is also conceivable that increase in ink discharge amount to the lower connection LC and the upper connection UC can more securely prevent exposure of each shoulder portion than increase in ink discharge amount to each inclined region E itself.

In this case, in ink discharge on the second scan, the ink discharge amount is defined uniform. That is, an ununiform ink discharge distribution is required at least one time among multiple scans.

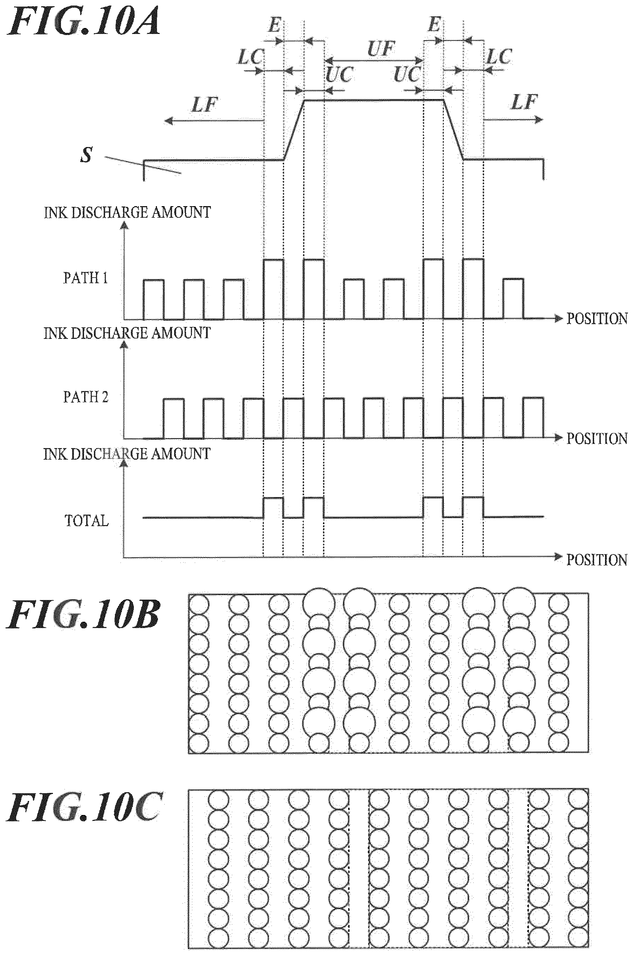

FIGS. 10A to 10C show Modification 3 of the ink discharge amount in the case of printing by two scans.

In a case of flexibly and easily adjusting the ink discharge amount to the three step regions, a combination of multiple types of ink discharge amounts can obtain the ink discharge amount according to the ratio as an average, instead of fixation of the ink discharge amount to each region.

In the example according to the ink discharge amount distribution in FIG. 10A, as shown in FIGS. 10B and 10C, discharge of a large ink droplet and discharge of a small (normal) ink droplet are alternately performed on a dot basis to the upper connection UC and the lower connection LC in the first scan. As an average, an intermediate droplet amount between the large ink droplet and the small ink droplet is supplied as an average to each of these upper connection UC and lower connection LC. In a range where the ink discharge amount does not become uneven, the ratio between the large ink droplet and the small ink droplet is appropriately adjusted, thus changing the average droplet amount. Accordingly, a discharge waveform pattern or the like is not required to be finely controlled for obtaining three or more degrees of ink discharge amounts.

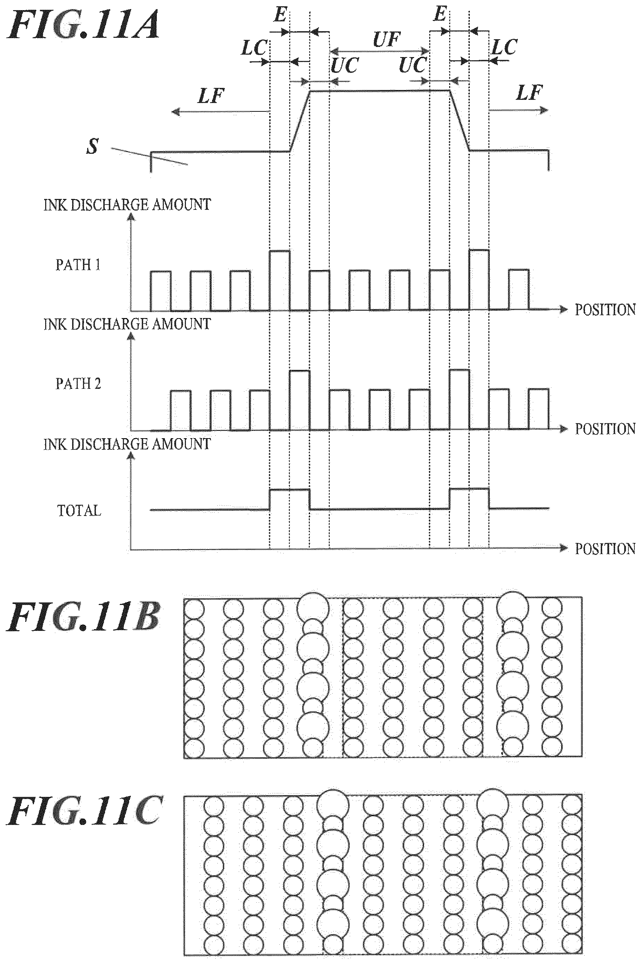

FIGS. 11A to 11C show Modification 4 of the ink discharge amount in the case of printing by two scans.

In a case of obtaining an ink discharge amount distribution shown in FIG. 11A, as shown in FIG. 11B, in the first scan, a large ink droplet is discharged to the lower connection LC on every other pixel, thereby increasing the supplied droplet amount as an average in comparison with the normal case. As shown in FIG. 11C, in the second scan, discharge of a large ink droplet and discharge of a small ink droplet are alternately performed to each inclined region E on every other pixel, thus supplying an intermediate droplet amount, as an average, between the normal ink discharge amount and the ink discharge amount of a large ink droplet.

Here, in the two scans, the timing of discharging the large ink droplet is the same. That is, in FIGS. 11B and 11C, ink droplets at odd-numbered orders from the top are large ink droplets. However, there is no limitation to this. To achieve alternate timing, for example, in the second scan, ink droplets on even-numbered orders from the top may be defined as large ink droplets.

The combinations of ink discharge with ink droplet amounts as shown in Modifications 3 and 4 are not limited to ink discharge in the multipath case. Likewise, also in ink discharge in the case of single path case, ink discharges with multiple ink droplet amounts may be combined, and an intermediate droplet amount may be provided as an average. The position setting for large and small ink droplets may be performed according to any of other various appropriate timing settings. For example, the large or small size of each ink droplet may be defined stochastically and randomly. Alternatively, large and small timings for ink droplets may be distributed by dithering or the like.

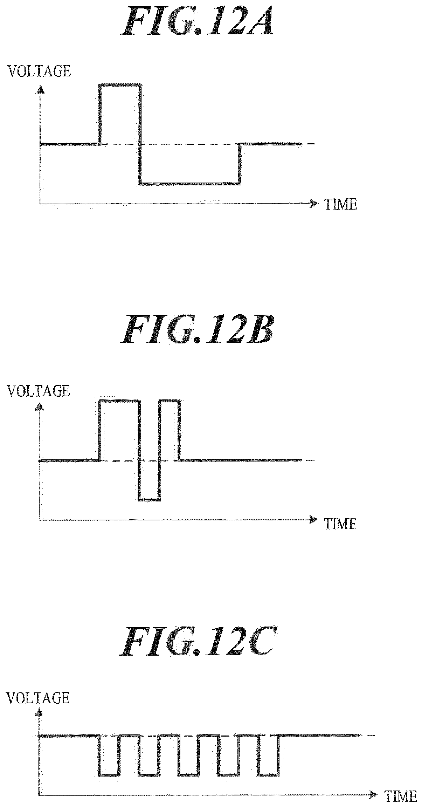

FIGS. 12A to 12C show examples of drive waveforms.

For example, in comparison with the ink droplet amount discharged by the waveform shown in FIG. 12A, the drive waveform in FIG. 12B indicates that the discharged ink droplet amount is small. According to the drive waveform pattern in a multi-drop scheme shown in FIG. 12C, adjustment can be performed so that part of continuous five pulses allowing the maximum output in an ink discharge cycle, which is obtained by, for example, removing a predetermined number of them from the beginning, form ink droplet amounts in accordance with the number of pulses, they are joined with each other during fight (or not necessarily joined), and are landed at the same pixel position.

As described above, the printing method by the inkjet recording device 1 in this embodiment is a printing method performed by discharging ink on a wiring substrate S having a step portion, wherein the step portion includes three regions that are an inclined region E that forms a step, an upper connection UC that is adjacent to the inclined region E and has a predetermined width, and a lower connection LC that is adjacent to the inclined region E and has a predetermined width, and the method includes a discharge amount setting step of increasing an ink droplet amount per ink discharge cycle of discharge to at least any selected region among the three regions, more than the ink droplet amount of discharge to what is other than the three regions. The ink droplet amount described here is an average discharge amount for each region. There is no limitation to a case of increasing the discharge amount to every pixel.

As described above, by making the ink droplet amount of discharge to and around the inclined region E larger than the normal amount, even if ink somewhat spreads on the landing surface (wiring substrate S), a possibility can be reduced that ink for covering specifically each upper corner (shoulder portion Es) in the inclined region E runs out and the corner is exposed. Accordingly, printing to a print surface having a step can be more reliably performed. That is, the ink landing range on the print medium surface can be more reliably covered with ink.

The ink to be discharged contains a gelator. By making ink landed on the landing surface become in the gel state and quickly adhere to the landing surface, wettability and spreading on the landing surface are suppressed, which can accurately perform printing.

The distribution of ink droplet amounts to the selected region is uneven. The spreading manner varies in accordance with the material of the wiring substrate S and the ink characteristics in addition to flowing down of ink along the step. Accordingly, adjustment of the distribution of ink droplet amounts in accordance with them allows the printing method to reliably perform printing with small unevenness.

The selected region includes at least two of the three regions; the ink droplet amounts to at least two regions are different from each other. The distribution of ink droplet amounts may be defined separately for each of the three step regions. Even by setting of the ink droplet amount for each of the three step regions in accordance with the difference between the flat portion and the inclined portion and with the difference in material between components, an appropriate print result can be easily and more reliably achieved without causing lack of printing where the wiring substrate S is unnecessarily exposed.

The selected region is defined in accordance with the material of the wiring substrate S. As described above, the spreading manner (wettability) is defined by the combination of the material of the wiring substrate S and the characteristics of the ink. Accordingly, by increasing the amount of ink discharged to an appropriate region in accordance with the material of the wiring substrate S, more accurate printing can be performed while avoiding lack of ink coverage.

The wiring substrate S includes the insulating substrate R, and the signal wiring C positioned on the insulating substrate R. The ink is solder mask ink. That is, in the print operation of forming the insulating film with the solder mask ink on the wiring substrate S, by performing adjustment of increasing the ink discharge amount at the step portion as described above, the insulation due to the cover film can be more reliably achieved.

The ink is cured by irradiation with predetermined energy rays. By quickly curing and fixing the ink landed on the wiring substrate S with the energy rays, in particular, by tentative and temporary fixation, flowing down of ink from the step can be suppressed, and a state of covering a desired range can be achieved.

The predetermined energy rays are ultraviolet light. By irradiation with ultraviolet light on the ink landing surface at appropriate timing, the ink can be cured in a desired state in accordance with the timing.

The ink may have a thermosetting property. Accordingly, a state can be prevented where after fixation, by temperature change and the like, the ink is brought into the sol state, the shape collapses, and the ink flows down.

The inkjet recording device 1 in this embodiment includes the inkjet head 20 that discharge ink, and the controller 50. In a case of performing printing by discharging ink on the wiring substrate S that has the step portion that includes three regions that are the inclined region E that forms a step, the upper connection UC that is adjacent to the inclined region E and has a predetermined width, and the lower connection LC that is adjacent to the inclined region E and has a predetermined width, the controller 50 (CPU 51) increases an ink droplet amount per ink discharge cycle of discharge to at least any selected region among the three regions, more than the ink droplet amount of discharge to what is other than the three regions.

By the inkjet recording device 1 performing such ink discharge control, even if ink somewhat spreads on the landing surface (wiring substrate S), a possibility can be reduced that ink for covering specifically each upper corner (shoulder portion Es) in the inclined region E runs out and the corner is exposed. Accordingly, printing on the print surface having a step can be more reliably performed.

Note that the present invention is not limited to the embodiment described above, and can be variously changed.

For example, in the embodiment described above, for the step three regions, the ink discharge amount is defined on a region-by-region basis or uniformly. However, the ink discharge amount is not necessarily uniform in each region. For example, from the upper connection UC to the upper flat portion UF, the ink discharge amount is gradually reduced, and is asymptotically reached and connected to a normal ink discharge amount at the flat portion UF.

Only at part, such as its upper half, of the inclined region E, the ink discharge amount may be increased.

In the embodiment described above, the inkjet head 20 is movable and the conveyance table 131 is also movable. However, in the case dedicated to single-path printing, only one is required to be movable. For example, only the conveyance table 131 is required to be movable. In this case, the inkjet head 20 may be fixed.

In the embodiment described above, description is performed assuming that the gelator is contained. However, there is no specific limitation to the gelator. Ink that has a high viscosity and is changeable depending on temperature change may be adopted.

In the aforementioned embodiment, description is performed assuming that ink having both the UV curability and thermosetting property is discharged. However, ink having only any of them may be adopted. Alternatively, ink that is cured by irradiation with energy rays other than UV light may be adopted.

In the embodiment described above, the case of printing and forming the insulating film on the wiring substrate S is described. However, there is no limitation to this. For example, a protective film printed and formed on another base component having a step (mainly what has no or little ink permeation; e.g., a resin component or a film) may be adopted. There is no limitation to the film. The technology described above may be applied also to a line, a diagram and a pattern formed on the base component, in order to suppress occurrence of abnormality in image quality and structure, such as discontinuity at the step portion in a similar manner. In such cases, the film thickness (ink discharge amount) may be appropriately changed in accordance with usage and the like.

Further alternatively, the specific configuration, details and procedures of the processing operation and the like can be appropriately changed in a range without departing from the spirit of the present invention. The scope of the present invention includes the scope of the invention described in the claims and its equivalent scope.

### INDUSTRIAL APPLICABILITY

The present invention is applicable to a printing method and an inkjet recording device.

### REFERENCE SIGNS LIST

1 Inkjet recording device
10 Conveyer
12 Scan driver
121 Scanner
122 Scan guide
13 Conveyance driver
131 Conveyance table
132 Conveyance guide
20 Inkjet head
22 Head driver
223 Electromechanical transducer
26 Recording element
28 Discharge selection IC
30 Head drive controller
31 Head controller
32 Drive waveform signal generation circuit
40 Fixer
42 UV irradiator
43 Heating fixer
50 Controller
60 Storage
61 Program
62 Image data
63 Thickness associated information
70 Ink heater
81 Display
82 Operation acceptor
90 Communicator
C Signal wiring
E Inclined region
Es Shoulder portion
I Insulating film
LC Lower connection
N Nozzle
P Connection pad
R Insulating substrate
S Wiring substrate
UC Upper connection

## Claims

1. A printing method performed by discharging ink on a base component having a step portion,
wherein the step portion includes three regions that are an inclined portion that forms a step, an upper adjacent portion that is adjacent to the inclined portion and has a predetermined width, and a lower adjacent portion that is adjacent to the inclined portion and has a predetermined width, and
the method includes a discharge amount setting step of increasing an ink droplet amount per ink discharge cycle of discharge to at least any selected region among the three regions, more than the ink droplet amount of discharge to what is other than the three regions.

2. The printing method according to claim 1, wherein the ink contains a gelator.

3. The printing method according to claim 1 or 2, wherein a distribution of the ink droplet amount to the selected region is uneven.

4. The printing method according to claim 3, wherein the selected region includes at least two of the three regions, and
the ink droplet amounts to the at least two regions are different from each other.

5. The printing method according to any one of claims 1 to 4, wherein the selected region is defined in accordance with a material of the base component.

6. The printing method according to any one of claims 1 to 5, wherein the base component is a wiring substrate that includes an insulating substrate, and a wiring conductor positioned on the insulating substrate, and
the ink is a solder mask ink.

7. The printing method according to any one of claims 1 to 6, wherein the ink is cured by irradiation with predetermined energy rays.

8. The printing method according to claim 7, wherein the predetermined energy rays are ultraviolet light.

9. The printing method according to any one of claims 1 to 8, wherein the ink has a thermosetting property.

10. An inkjet recording device, comprising:
a discharge operator that discharges ink; and
a controller,
wherein
when printing is performed by discharging ink on a base component including a step portion that includes three regions that are an inclined portion that forms a step, an upper adjacent portion that is adjacent to the inclined portion and has a predetermined width, and a lower adjacent portion that is adjacent to the inclined portion and has a predetermined width,
the controller increases an ink droplet amount per ink discharge cycle of discharge to at least any selected region among the three regions, more than the ink droplet amount of discharge to what is other than the three regions.
